# EUROPEAN PATENT SPECIFICATION

(11) **EP 3 712 550 B1**
(45) Date of publication and mention of the grant of the patent: **26.04.2023**
(21) Application number: 20162115.8
(22) Date of filing: 10.03.2020
(51) Int. Cl.: F28D 20/02, F28F 3/02, H01L 23/367, H01L 23/373, H01L 23/427, H05K 7/20, F28D 20/00, F28D 21/00

(54) **PIN FIN HEAT SINK WITH INTEGRATED PHASE CHANGE MATERIAL AND METHOD**
STIFTRIPPENKÜHLKÖRPER MIT INTEGRIERTEM PHASENWECHSELMATERIAL UND VERFAHREN
DISSIPATEUR THERMIQUE À AILETTE DE BROCHE AVEC MATÉRIAU À CHANGEMENT DE PHASE INTÉGRÉ ET PROCÉDÉ

(30) Priority: 19.03.2019 US 201916358262
(43) Date of publication of application: 23.09.2020
(73) Proprietor: Hamilton Sundstrand Corporation, Charlotte, NC 28217-4578 (US)
(72) Inventor: BOURAS, Scott R., Rockford, IL Illinois 61109 (US)
(74) Representative: Dehns

(56) References cited:
- EP-A1- 3 301 392
- WO-A1-2016/062577
- US-A1- 2004 170 806
- US-A1- 2014 090 808

## Description

### BACKGROUND

Exemplary embodiments pertain to the art of heat sink and, more particularly, to a pin fin heat sink, as well as a method of manufacturing a pin fin heat sink.

Heat sinks capable of drawing heat from one place and dissipating it in another place are known and are used in numerous applications where efficiently removing heat is desirable. One type of heat sink used in fluid cooling systems dissipates heat from two parallel fluid passages into a cooling fluid passage between the passages. A cooling fluid (such as air) is then passed through the cooling fluid passage. Heat from the parallel fluid passages is drawn into the cooling fluid passage and is expelled at the opposite end of the heat sink with the cooling fluid.

Electronic devices such as those used for power electronics in aircraft applications or directed energy weapons often experience periodic load transients that produce peak thermal loads. During times of peak thermal loads, the thermal capacity of the cooling fluid may be exceeded leading to a steep rise in the electronic device temperature. Alternatively, a temporary reduction in the cooling capacity of the heat sink can also lead to a significant rise in the electronic device temperature. EP3301392A1 relates to a pin fin heat sink with integrated phase change material. WO2016062577A1 relates to a low weight tube fin heat sink. US2014090808A1 relates to a heat-transfer device.

### BRIEF DESCRIPTION

Disclosed is a pin fin heat sink including a plurality of pin fins extending from a base plate, at least one of the plurality of pin fins defining a hollow portion therein. The pin fin heat sink also includes an annular ring of metal foam material disposed within the hollow portion, the annular ring of metal foam material having a radially outer surface in direct contact with an inner diameter of the pin fin, the annular ring of metal foam material defining a central cavity. The pin fin heat sink further includes a phase change material disposed within the central cavity.

Also disclosed is a pin fin heat sink including a plurality of pin fins extending from a base plate, at least one of the plurality of pin fins defining a hollow portion therein. The pin fin heat sink also includes an annular ring of metal foam material disposed within the hollow portion, the annular ring of metal foam material impregnated with a phase change material and defining a central cavity, the central cavity at least partially filled with phase change material.

### BRIEF DESCRIPTION OF THE DRAWINGS

The following descriptions should not be considered limiting in any way. With reference to the accompanying drawings, like elements are numbered alike:
FIG. 1 is an elevational view of a pin fin heat sink;
FIG. 2 is a top plan view of the pin fin heat sink;
FIG. 3 is an enlarged view of Section A of FIG. 1, illustrating one pin fin of the pin fin heat sink, which does not form part of this invention;
FIG. 4 is an enlarged view of Section A of FIG. 1, illustrating one pin fin of the pin fin heat sink according to this invention; and
FIG. 5 is a cross-sectional view taken along line A-A of FIG. 4.

### DETAILED DESCRIPTION

A detailed description of one or more embodiments of the disclosed apparatus are presented herein by way of exemplification and not limitation with reference to the Figures.

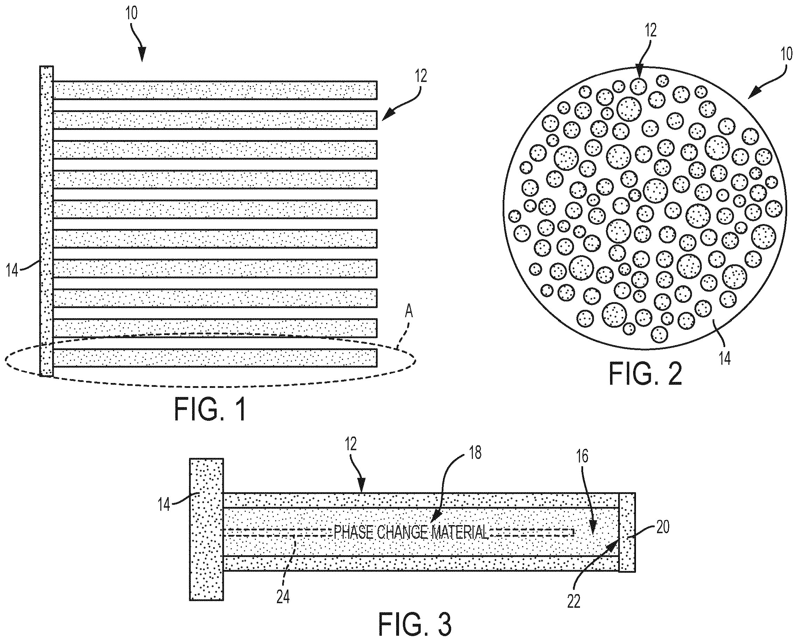

Referring to FIGS. 1 and 2, a portion of a pin fin heat sink is illustrated and generally referenced with numeral 10. In order to increase the surface area exposed to a cooling fluid in a cooling fluid passage, and thereby increase the heat transfer potential of the heat sink, a plurality of thermally conductive pins 12 are provided. The pins 12 conduct heat away from a zone to be cooled and into the cooling fluid passage, thereby exposing more surface area to the cooling fluid flowing through the cooling fluid passage. Since the amount of heat dissipated in the heat sink 10 is proportional to the surface area exposed to the cooling fluid, and the pins 12 generate more exposed surface area, the efficiency of the heat sink 10 is increased.

As shown, a plurality of pins 12 are operatively connected to, and extend from, a base plate 14. The pins 12 may be arranged in various contemplated manners. For example, each of the pins 12 may be formed of an equal diameter and extend an equal length away from the base plate 14. Alternatively, the diameters of at least one of the pins 12 may be distinct from at least one of the other pins 12. In some embodiments, all of the pins 12 have distinct diameters. Similarly, the length of at least one of the pins 12 may be distinct from at least one of the other pins 12. In some embodiments, all of the pins 12 have distinct lengths. A combination of distinct diameters and lengths is provided in some embodiments. By varying the diameters and/or lengths of the pins 12, a turbulent flow is induced, thereby enhancing heat transfer.

Referring to FIG. 3, an enlarged illustration of one of the pins 12 is provided, which does not represent this invention. In contrast to solid fins of any shape, and particularly in contrast to solid cylindrical pins of other heat sinks, the pins 12 disclosed herein define a hollow portion 16 therein. In the illustrated embodiment, the hollow portion 16 extends substantially along nearly an entire length of the pin 12, but it is to be appreciated that the hollow portion 16 may extend only partially along the length of the pin 12 in some embodiments.

The pin 12 may be formed and connected to the base plate 14 in various contemplated manners. For example, the pin 12 may be an extruded hollow tube that is brazed to the base plate 14. Alternatively, an additive manufacturing process may be employed to build up the hollow tube from the base plate 14, with the hollow portion 16 defined therein. In either embodiment, a phase change material 18 is introduced into the hollow portion 16 of the pin 12. The pin 12 then has a cap 20 positioned on an open end 22 of the pin 12 and it is brazed thereto, thereby sealing the phase change material within the hollow portion 16. It is contemplated that alternative manufacturing processes are employed, such as connecting a pin that is pre-filled with the phase change material 18 to the base plate 14 or filling a pin with the phase change material 18 that is integrally formed with the base plate 14.

The phase change material 18 comprises paraffin wax in some embodiments, but it is to be understood that any suitable phase change material is contemplated and may vary depending on the particular conditions of different applications. Integrating the phase change material 18 into the pins 12 enables the heat sink 10 to absorb transient thermal loads without a spike in the device temperature. During a transient event, the phase change material 18 absorbs the thermal energy and changes phase at a constant temperature. After the transient event, the latent heat is rejected as the phase change material 18 reverts back to its original state. This improves over conventional solid heat sinks which lack latent heat storage and would experience sensible heating during the peak thermal load.

A metal foam material 24 is provided in the hollow portion 16 to increase the thermal conductivity of the phase change material 18 disposed in the hollow portion 16 of the pin 12. In some examples, the metal foam material 24 is positioned along a central portion of the hollow portion 16, as shown in figure 3. In other examples, the metal foam material 24 extends radially to the inner walls of the pin 12 that defines the hollow portion 16. The metal foam material 24 is impregnated with the phase change material during manufacture.

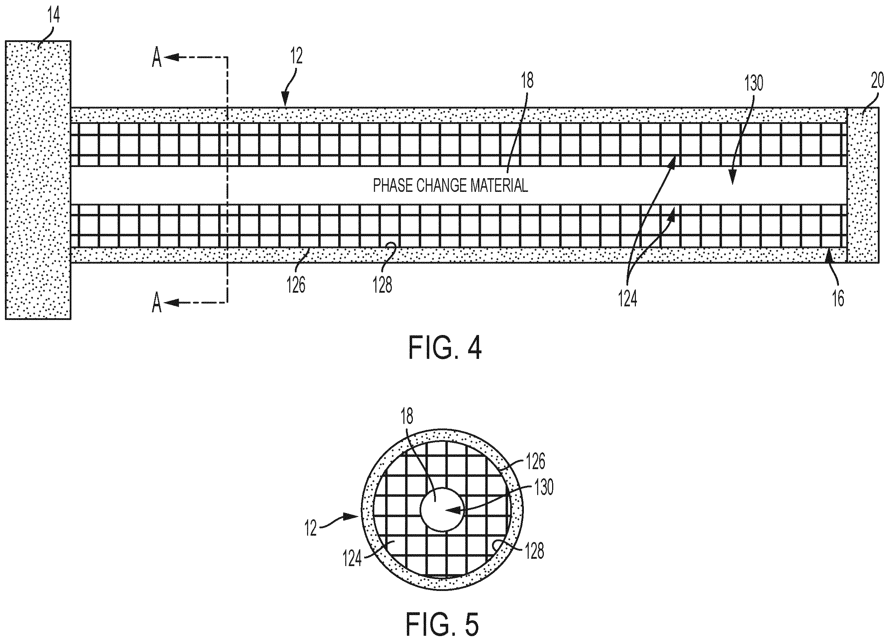

Referring now to FIGS. 4 and 5, an enlarged illustration of one of the pins 12 is shown according to this invention. In the illustrated embodiment, an annular ring of metal foam material 124 is provided in the hollow portion 16 in some embodiments to increase the thermal conductivity of the phase change material 18 disposed in the hollow portion 16 of the pin 12. The annular ring of metal foam material 124 includes a radially outer surface 126 in contact with an inner diameter 128 of the pin 12. Direct contact between the annular ring 124 and the pin 12 conducts heat to the outer wall of the pin 12. As with the embodiments described above, the annular ring of metal foam material 124 is impregnated with the phase change material during manufacture. The annular ring of metal foam material 124 defines a central cavity 130 that purely contains phase change material 18 therein for further latent heat storage. In some embodiments, the central cavity is positioned to extend substantially along a central axis of the pin 12 and/or the hollow portion 16.

The size of the annular ring can be optimized based upon the specific application to balance latent heat capacity (utilizing phase change material) with thermal conduction from the heat source (utilizing metal foam and the solid pin wall).

Although a single pin is described in detail above, it is to be appreciated that more than one of the pins 12 includes the hollow portion 16 and phase change material 18 in some embodiments. Furthermore, all of the plurality of pins 12 includes the hollow portion 16 and phase change material 18 in some embodiments.

Advantageously, the embodiments disclosed herein enable the heat sink 10 to better handle transient thermal loads that the heat sink 10 is subjected to during operation.

The term "about" is intended to include the degree of error associated with measurement of the particular quantity based upon the equipment available at the time of filing the application. For example, "about" can include a range of ± 8% or 5%, or 2% of a given value.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

## Claims

1. A pin fin heat sink comprising:
a plurality of pin fins (12) extending from a base plate (14), at least one of the plurality of pin fins defining a hollow portion (16) therein;
**characterised by** comprising:
an annular ring of metal foam material (124)
disposed within the hollow portion, the annular ring of metal foam material having a radially outer surface in direct contact with an inner diameter of the pin fin, the annular ring of metal foam material defining a central cavity (130); and
a phase change material (18) disposed within the central cavity.

2. The pin fin heat sink of claim 1, wherein at least one of the pin fins (12) is formed of a diameter that is different than at least one of the remaining pin fins.

3. The pin fin heat sink of claim 1, wherein all of the pin fins (12) have different diameters relative to each other.

4. The pin fin heat sink of any preceding claim, wherein the phase change material (18) comprises paraffin wax.

5. The pin fin heat sink of any preceding claim, wherein the pin fins (12) are brazed to the base plate.

6. The pin fin heat sink of any preceding claim, wherein the pin fins (12) are additively manufactured to be connected, and extend from, the base plate (114).

7. The pin fin heat sink of any preceding claim, wherein the central cavity is positioned to extend along a central axis of the pin.

8. The pin fin heat sink of any preceding claim, wherein the central cavity is positioned to extend along a central axis of the hollow portion.

9. The pin fin heat sink of any preceding claim, wherein the annular ring of metal foam material is impregnated with a phase change material to define the central cavity, the central cavity at least partially filled with the phase change material.

## Patentansprüche

1. Stiftrippenkühlkörper, umfassend:
eine Vielzahl von Stiftrippen (12), die sich von einer Basisplatte (14) erstreckt, wobei mindestens eine der Vielzahl von Stiftrippen einen hohlen Abschnitt (16) darin definiert;
**dadurch gekennzeichnet, dass** er Folgendes umfasst:
einen Kreisring aus Metallschaummaterial (124), der innerhalb des hohlen Abschnitts angeordnet ist, wobei der Kreisring aus Metallschaummaterial eine radial äußere Oberfläche in direktem Kontakt mit einem Innendurchmesser der Stiftrippe aufweist, wobei der Kreisring aus Metallschaummaterial einen zentralen Hohlraum (130) definiert; und
ein Phasenwechselmaterial (18), das innerhalb des zentralen Hohlraums angeordnet ist.

2. Stiftrippenkühlkörper nach Anspruch 1, wobei mindestens eine der Stiftrippen (12) mit einem Durchmesser ausgebildet ist, der sich von mindestens einer der übrigen Stiftrippen unterscheidet.

3. Stiftrippenkühlkörper nach Anspruch 1, wobei alle Stiftrippen (12) relativ zueinander unterschiedliche Durchmesser aufweisen.

4. Stiftrippenkühlkörper nach einem der vorhergehenden Ansprüche, wobei das Phasenwechselmaterial (18) Paraffinwachs umfasst.

5. Stiftrippenkühlkörper nach einem der vorhergehenden Ansprüche, wobei die Stiftrippen (12) an die Basisplatte gelötet sind.

6. Stiftrippenkühlkörper nach einem der vorhergehenden Ansprüche, wobei die Stiftrippen (12) additiv hergestellt sind, um mit der Basisplatte (114) verbunden zu werden und sich von dieser zu erstrecken.

7. Stiftrippenkühlkörper nach einem der vorhergehenden Ansprüche, wobei der zentrale Hohlraum so positioniert ist, dass er sich entlang einer Mittelachse des Stifts erstreckt.

8. Stiftrippenkühlkörper nach einem der vorhergehenden Ansprüche, wobei der zentrale Hohlraum so positioniert ist, dass er sich entlang einer Mittelachse des hohlen Abschnitts erstreckt.

9. Stiftrippenkühlkörper nach einem der vorhergehenden Ansprüche, wobei der Kreisring aus Metallschaummaterial mit einem Phasenwechselmaterial imprägniert ist, um den zentralen Hohlraum zu definieren, wobei der zentrale Hohlraum mindestens teilweise mit dem Phasenwechselmaterial gefüllt ist.

## Revendications

1. Dissipateur thermique à ailettes à broches comprenant :
une pluralité d'ailettes à broches (12) s'étendant à partir d'une plaque de base (14), au moins l'une de la pluralité d'ailettes à broches définissant une partie creuse (16) dans celle-ci ;
caractérisé en comprenant :
une bague annulaire en matériau de mousse métallique (124) disposée à l'intérieur de la partie creuse, la bague annulaire en matériau de mousse métallique ayant une surface radialement externe en contact direct avec un diamètre interne de l'ailette à broches, la bague annulaire en matériau de mousse métallique définissant une cavité centrale (130) ; et
un matériau à changement de phase (18) disposé à l'intérieur de la cavité centrale.

2. Dissipateur thermique à ailettes à broches selon la revendication 1, dans lequel au moins l'une des ailettes à broches (12) est formée d'un diamètre qui est différent de celui d'au moins une des ailettes à broches restantes.

3. Dissipateur thermique à ailettes à broches selon la revendication 1, dans lequel toutes les ailettes à broches (12) ont des diamètres différents les unes par rapport aux autres.

4. Dissipateur thermique à ailettes à broches selon une quelconque revendication précédente, dans lequel le matériau à changement de phase (18) comprend de la cire de paraffine.

5. Dissipateur thermique à ailettes à broches selon une quelconque revendication précédente, dans lequel les ailettes à broches (12) sont brasées à la plaque de base.

6. Dissipateur thermique à ailettes à broches selon une quelconque revendication précédente, dans lequel les ailettes à broches (12) sont fabriquées de manière additive pour être connectées à la plaque de base (114) et s'étendre à partir de celle-ci.

7. Dissipateur thermique à ailettes à broches selon une quelconque revendication précédente, dans lequel la cavité centrale est positionnée pour s'étendre le long d'un axe central de la broche.

8. Dissipateur thermique à ailettes à broches selon une quelconque revendication précédente, dans lequel la cavité centrale est positionnée pour s'étendre le long d'un axe central de la partie creuse.

9. Dissipateur thermique à ailettes à broches selon une quelconque revendication précédente, dans lequel la bague annulaire en matériau de mousse métallique est imprégnée d'un matériau à changement de phase pour définir la cavité centrale, la cavité centrale étant au moins partiellement remplie du matériau à changement de phase.
